# EUROPÄISCHE PATENTSCHRIFT

(11) **EP 1 320 897 B1**
(45) Veröffentlichungstag und Bekanntmachung des Hinweises auf die Patenterteilung: **05.12.2012**
(21) Anmeldenummer: 01985777.0
(22) Anmeldetag: 27.08.2001
(51) Int. Cl.: H01L 29/32, H01L 29/861

(54) **VERFAHREN ZUM HERSTELLEN EINES HALBLEITERBAUELEMENTS AUS HALBLEITERMATERIAL MIT REDUZIERTER MITTLERER FREIER WEGLÄNGE UND MIT DEM VERFAHREN HERGESTELLTES HALBLEITERBAUELEMENT**
METHOD FOR PRODUCING A SEMICONDUCTOR DEVICE CONSISTING OF SEMICONDUCTOR MATERIAL HAVING A REDUCED MEAN FREE PATH LENGTH AND SEMICONDUCTOR DEVICE FABRICATED THEREBY
PROCEDE DE FABRICATION D'UN DISPOSITIF À SEMI-CONDUCTEUR EN MATERIAU SEMI-CONDUCTEUR PRESENTANT UNE LONGUEUR DE PARCOURS LIBRE MOYENNE REDUITE ET DISPOSITIF À SEMI-CONDUCTEUR FABRIQUÉ PAR LE PROCÉDÉ

(30) Priorität: 29.09.2000 DE 10048437
(43) Veröffentlichungstag der Anmeldung: 25.06.2003
(73) Patentinhaber: Infineon Technologies AG, 85579 Neubiberg (DE)
(72) Erfinder: KARTAL, Veli, 81371 München (DE); SCHULZE, Hans-Joachim, 85521 Ottobrunn (DE)
(74) Vertreter: Schmuckermaier, Bernhard
(86) Internationale Anmeldenummer: PCT/EP2001/009866
(87) Internationale Veröffentlichungsnummer: WO 2002/027802

(56) Entgegenhaltungen:
- EP-A- 0 327 316
- EP-A- 0 889 509
- EP-A2- 0 622 834
- WO-A-00/07245
- WO-A-98/15010
- DE-A- 10 030 381
- US-A- 4 717 681
- US-A- 4 935 386
- US-A- 5 102 810
- US-A- 5 159 429
- US-A- 5 858 855
- QUEIROLO G.; POLIGNANO M.L.: "Incremental sheet resistance and spreading resistance: a comparison", JOURNAL OF VACUUM SCIENCE & TECHNOLOGY B (MICROELECTRONICS PROCESSING AND PHENOMENA), vol. 10, no. 1, 1992, pages 408-412, USA
- ANG S S ET AL: "Growth and characterization of germanium and boron doped silicon epitaxial films", JOURNAL OF ELECTRONIC MATERIALS, WARRENDALE, PA, US, vol. 17, no. 1, 1 January 1988 (1988-01-01), pages 39-43, XP009096440, ISSN: 0361-5235, DOI: 10.1007/BF02652231
- KOLA R R ET AL: "Defect and dopant control during silicon epitaxy using B and Ge", DEFECTS IN ELECTRONIC MATERIALS. SYMPOSIUM, 30 NOV.-3 DEC. 1987, BOSTON, MA, USA, 30 November 1987 (1987-11-30), - 3 December 1987 (1987-12-03), pages 641-644, XP009096435, Pittsburgh, PA, USA ISBN: 0-931837-72-3

## Beschreibung

Die Erfindung betrifft ein Verfahren zum Herstellen eines Halbleiterbauelements mit einem Körper aus dotiertem Halbleitermaterial mit einer bestimmten mittleren freien Weglänge für freie Ladungsträger und einer mittleren freien Weglänge für die freien Ladungsträger, die kleiner als die bestimmte mittlere freie Weglänge ist.

Ein Körper der genannten Art ist in der älteren deutschen Patentanmeldung 100 30 381.1(=2000P12486 DE) vorgeschlagen, dessen Inhalt Bestandteil der vorliegenden Anmeldung ist. Dieser Körper weist einen Übergang zwischen dotiertem Halbleitermaterial eines Leitfähigkeitstyps und dotiertem Halbleitermaterial eines zum einen Leitfähigkeitstyp entgegengesetzten Leitfähigkeitstyps auf. Durch die kleinere mittlere freie Weglänge wird die Sperrfähigkeit des Körpers erhöht. Bei einem mit diesem Körper hergestellten elektronischen Bauelement kann es zu einer Minimierung von während eines Betriebs dieses Bauelements im Körper auftretenden Schalt- und Durchlassverlusten wünschenswert sein, die mittlere freie Weglänge nicht im gesamten Körper, sondern lokal nur dort zu reduzieren, in welchem während eines Sperrzustandes des Bauelements hohe elektrische Feldstärken auftreten.

Die EP 0 327 316 beschreibt ein Bauelement, das aus zwei verbundenen Halbleitersubstraten besteht. In einem der Substrate werden Kristalldefekte als Rekombinationszentren zur Reduzierung der Ladungsträgerlebensdauer eingebracht, bevor die Substrate verbunden werden.

In der US 5,102,810 ist ein bipolarer Leistungsgleichrichter offenbart, bei dem die Lebensdauer der Minoritätsladungsträger durch Gitterfehlanpassungen reduziert wird. Die Gitterfehlanpassungen werden über zusätzlich eingebrachte Schichten erzeugt.

Die US 5,858,855 beschreibt ein Bauelement, bei dem zur Reduzierung der Minoritätsladungslebensdauer zusätzliche Schichten aus polykristallinem Silizium vorhanden sind.

Die EP 0 889 509 beschreibt ein Halbleiterbauelement, bei dem ausschließlich Grenzflächengitterfehlstellen als Rekombinationszentren eingesetzt werden.

Die WO 00/07245 offenbart ein Leistungshalbleiterbauelement mit einem Rekombinationsbereich, der Sauerstoffausscheidungen umfassende Rekombinationszentren aufweist.

Die WO 98/15010 offenbart einen Thyristor, der eine Rekombinationszone für eine reduzierte Lebensdauer der freien Ladungsträger aufweist.

Die EP 0 622 834 A2 beschreibt ein Verfahren zur Herstellung eines Halbleiterbauelements. Bei diesem Verfahren wird eine Halbleiterschicht bereitgestellt, in die neutrale Fremdatome mit großem Durchmesser implantiert werden, um dadurch Streuzentren zu erzeugen.

Der Verlust an freien Ladungsträgern durch Rekombination ist nachteilig, da diese Ladungsträger zum Ladungsträgertransport nicht zur Verfügung stehen und einen zusätzlichen Abfall an Durchlassspannung an einem pn-Übergang eines Gleichrichters verursachen.

Aufgabe der Erfindung ist es, ein einfaches Verfahren zur Herstellung eines Halbleiterbauelements mit einem Körper der genannten Art bereitzustellen, der einen nur lokal und nicht über den ganzen Körper sich erstreckenden Bereich reduzierter mittlerer freier Weglänge aufweist, und ein entsprechendes Halbeiterbauelement zur Verfügung zur stellen.

Diese Aufgabe wird durch das im Anspruch 1 angegebene Verfahren und durch das Bauelement gemäß Ansprunch 6 gelöst.

Die Streuzentren reduzieren die bestimmte mittlere freie Weglänge für die freien Ladungsträger der Kristallschicht, so dass die Kristallschicht mit den Streuzentren eine kleinere mittlere freie Weglänge für die freien Ladungsträger aufweist.

Die Streuzentren können über die ganze Fläche der Kristallschicht verteilt sein, so dass die mittlere frei Weglänge der Kristallschicht über der ganzen Fläche der Kristallschicht reduziert ist, oder sie können vorteilhafterweise nur lokal an einer oder mehreren bestimmten Stellen der Fläche der Kristallschicht vorhanden sein, so dass die mittlere freie Weglänge nur über einem Teil der Fläche der Kristallschicht reduziert ist. In jedem Fall ist die reduzierte mittlere freie Weglänge im Wesentlichen nur auf die Ausdehnung der Kristallschicht beschränkt und erstreckt sich nicht auf Bereiche des Körpers außerhalb der Kristallschicht.

"Nichtdotierend" bedeutet, dass die Fremdstoffpartikeln keinen Einfluss auf eine Leitfähigkeit des dotierten Halbleitermaterials hat, in das sie eingebracht werden. Die Fremdstoffpartikeln wirken im Halbleitermaterial lediglich als Streuzentren, welche die im Halbleitermaterial bereits vorhandene mittlere freie Weglänge reduzieren.

Streuzentren werden durch Beigabe nichtdotierender Germanium und/oder Kohlenstoffatome während des Wachsens der Kristallschicht in der Kristallschicht erzeugt.

Dabei wird während des Wachsens der Kristallschicht eine zur Erzeugung von Streuzentren in der Kristallschicht angebotene Menge nichtdotierender Fremdstoffpartikeln zeitlich variiert. Dadurch kann vorteilhafterweise eine örtliche Variation der reduzierten mittleren freien Weglänge in Richtung vertikal zur Fläche der Kristallschicht erhalten werden.

Streuzentren können zusätzlich auch durch Eindiffundieren nichtdotierender Fremdstoffpartikel in die Kristallschicht erzeugt werden.

Bevorzugter- und vorteilhafterweise wird auf die Kristallschicht mit der kleineren mittleren freien Weglänge für die freien Ladungsträger weiteres dotiertes Halbleitermaterial aufgebracht, das eine mittlere freien Weglänge für die freien Ladungsträger aufweist, die gleich oder größer als die bestimmte mittlere freie Weglänge für die freien Ladungsträger ist.

Das weitere dotierte Halbleitermaterial kann vorteilhafterweise zumindest eine durch Epitaxie auf die Kristallschicht mit der kleineren mittleren freien Weglänge gewachsene Kristallschicht aus dotiertem Halbleitermaterial aufweisen, es kann auch einen Kristallkörper aus dotiertem Halbleitermaterial aufweisen, der durch Waferbonden mit einer freiliegenden Kristallschicht auf dem Substratkristall verbunden ist. Der Kristallkörper kann demgemäß mit der Kristallschicht mit der kleineren mittleren freien Weglänge oder mit einer auf dieser Kristallschicht gewachsenen Kristallschicht verbunden sein.

Vorzugs- und vorteilhafterweise weist das weitere dotierte Halbleitermaterial einen Leitfähigkeitstyp auf, der entgegengesetzt zu einem Leitfähigkeitstyp des Substratskristalls ist.

Die Erfindung wird in der nachfolgenden Beschreibung anhand der Zeichnungen beispielhaft näher erläutert. Es zeigen:
- Figur 1: in Seitenansicht einen Substratkristall aus dotiertem Halbleitermaterial als Ausgangsstufe eines beispielhaften erfindungsgemäßen Verfahrens,
- Figur 2: den Substratkristall nach Figur 1 während des Wachsens einer epitaktischen Kristallschicht aus dotiertem Halbleitermaterial auf dem Substratkristall unter Beigabe nichtdotierender Fremdstoffpartikeln, die Streuzentren in der Kristallschicht erzeugen,
- Figur 3: den Körper aus dotiertem Halbleitermaterial nach Figur 2 nach Abschluss des Wachsens der epitaktischen Kristallschicht aus dotiertem Halbleitermaterial auf dem Substratkristall unter Beigabe nichtdotierender Fremdstoffpartikeln, die Streuzentren in der Kristallschicht erzeugen,
- Figur 4: den Körper aus dotiertem Halbleitermaterial nach Figur 3 nach einem Aufbringen von weiterem dotierten Halbleitermaterial auf die epitaktische Kristallschicht,
- Figur 5: in Seitenansicht einen Körper, bestehend aus einem einkristallinen Kristallkörper aus dotiertem Halbleitermaterial, der einen Bereich aufweist, in welchem eine mittlere freie Weglänge für freie Ladungsträger reduziert ist, und aus einem weiteren einkristallinen Kristallkörper aus dotiertem Halbleitermaterial, der mit dem einen Kristallkörper verbunden ist, wobei die Verbindung durch Waferbonden hergestellt ist, und
- Figur 6: in Seitenansicht den einen Kristallkörper während der Herstellung des Bereichs reduzierter mittlerer freier Weglänge durch Erzeugung von Streuzentren im Kristallkörper.

Die Figuren sind schematisch und nicht maßstäblich.

Bei dem beispielhaften Verfahren wird auf einer Oberfläche eines Substratkristalls 10 aus dotiertem Halbleitermaterial, beispielsweise auf der nach oben gekehrten Oberfläche 11 des Kristalls 10, durch Epitaxie eine Kristallschicht aus dotiertem Halbleitermaterial gewachsen, wobei das Halblertermaterial Silicium ist.

Das dotierte Halbleitermaterial des Substratkristalls 10 ist beispielsweise n-dotiert und weist eine bestimmte mittlere freie Weglänge für freie Ladungsträger CP, im Beispielsfall größtenteils Elektronen, auf. Ist das Halbleitermaterial des Substratkristalls 10 p-dotiert, sind die freien Ladungsträger CP größtenteils Löcher.

Die bestimmte mittlere freie Weglänge für die freien Ladungsträger CP des Substratkristalls 10 ist beispielsweise die im dotierten Halbleitermaterial des Substratkristalls 10 natürlich vorhandene mittlere freie Weglänge λn für die freien Ladungsträger CP.

Das dotierte Halbleitermaterial der zu wachsenden Kristallschicht ist beispielsweise vom gleichen Leitfähigkeitstyp wie das dotierte Halbleitermaterial des Substratkristalls 10 gewählt, im Beispielsfall also n-dotiert.

Wie das Halbleitermaterial des Substratkristalls 10 weist das dotierte Halbleitermaterial der zu wachsenden Kristallschicht eine bestimmte mittlere freie Weglänge für die freien Ladungsträger CP auf, welche die im dotierten Halbleitermaterial der zu wachsenden Kristallschicht natürlich vorhandene mittlere freie Weglänge für die freien Ladungsträger CP, im Beispielfall größtenteils die Elektronen, sein kann.

Wird das Halbleitermaterial der zu wachsenden Kristallschicht derart verschieden vom Halbleitermaterial des Substratkristalls 10 gewählt, dass die bestimmte mittlere freie Weglänge für die freien Ladungsträger CP der zu wachsenden Kristallschicht kleiner als die bestimmte mittlere freie Weglänge für die gleichen freien Ladungsträger CP des Substratkristalls 10 ist, so kann ein erfindungsgemäßes Bauelement realisiert, werden.

Vorzugsweise wird jedoch zumindest für einen an den Substratkristall 10 grenzenden Teil der zu wachsenden Kristallschicht das gleiche dotierte Halbleitermaterial wie für den Substratkristall 10 verwendet, das sowohl für zumindest diesen Teil der zu wachsenden Kristallschicht als auch den Substratkristall 10 die gleiche bestimmte mittlere freie Weglänge λn für die gleichen freien Ladungsträger CP aufweist, und die vergleichsweise kleinere mittlere freie Weglänge für die gleichen freien Ladungsträger CP wird durch Erzeugen von Streuzentren in der Kristallschicht hergestellt, welche die bestimmte mittlere freie Weglänge für die freien Ladungsträger CP der Kristallschicht reduzieren.

Die Streuzentren in der Kristallschicht werden durch Einbringen von nichtdotierendan Fremdstoffpartikeln in die Kristallschicht erzeugt, nämlich durch Beigabe nichtdotierender Fremdstoffpartikeln während des Wachsens der Kristallschicht zu dieser Schicht.

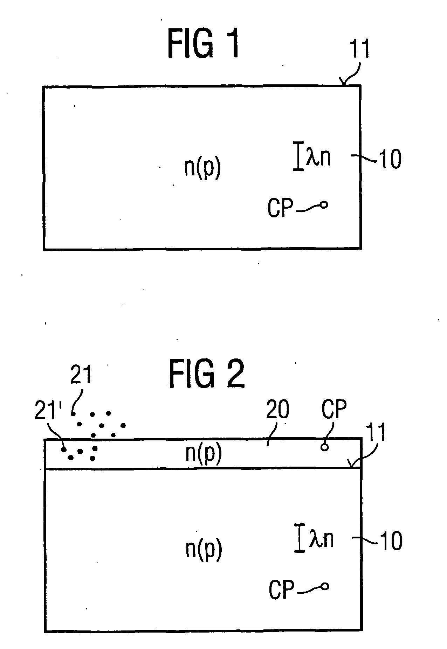

In der Figur 2 ist dies näher veranschaulicht. Die Figur 2 zeigt den Substratkristall 10 während des epitaktischen Wachsens der Kristallschicht auf der Oberfläche 11 des Substratkristalls 10, wobei ein an den Substratkristall 10 grenzender Teil der mit 20 bezeichneten Kristallschicht auf dieser Oberfläche 11 bereits gewachsen ist.

Zum Wachsen der Kristallschicht 20 kann beispielsweise Flüssigphasen-, Gasphasen- und/oder Molekularstrahl-Epitaxie verwendet werden.

Der Phase und/oder dem Molekularstrahl werden beispielsweise die nichtdotierenden Fremdstoffpartikeln, beispielsweise nichtdotierende Fremdstoffatome beigegeben, die in der Figur 2 durch Punkte 21 angedeutet sind und in der auf der Oberfläche 11 des Substratkristalls gewachsenen Kristallschicht 20 Streuzentren 21' definieren.

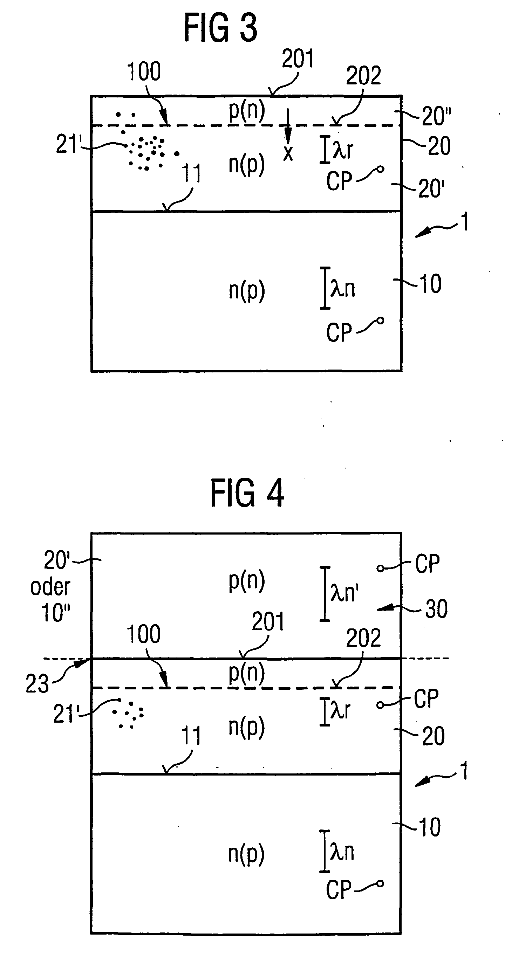

Nach Abschluss der Epitaxie ist der in der Figur 3 dargestellte beispielhafte Körper 1 mit der Kristallschicht 20 entstanden, in welcher durch die eingebrachten Streuzentren 21' die bestimmte mittlere freie Weglänge λn für die freien Ladungsträger CP auf die kleinere mittlere freie Weglänge λr für diese Ladungsträger CP reduziert ist.

Die nichtdotierenden Streuzentren 21' können über der ganzen Fläche der Kristallschicht 20 in der Schicht 20 verteilt sein, beispielsweise gleichmäßig. Diese Fläche ist beispielsweise durch die vom Substratkristall 10 abgekehrte Fläche 201 der Kristallschicht 20 repräsentiert. In diesem Fall ist die mittlere freie Weglänge für die freien Ladungsträger über der ganzen Fläche 201 reduziert.

Die Streuzentren 21' können auch nur über einem oder mehreren Teilbereichen der Fläche 201 in der Kristallschicht 20 verteilt sein und außerhalb dieser Teilbereiche fehlen. In diesem Fall ist die mittlere freie Weglänge für die freien Ladungsträger nur über dem oder den Teilbereichen reduziert und außerhalb dieser Teilbereiche liegt in der Schicht 20 die bestimmte mittlere freie Weglänge λn für die freien Ladungsträger CP vor.

Während des Wachsens der Kristallschicht 20 wird eine zur Erzeugung von Streuzentren 21' in der Kristallschicht 20 angebotene Menge nichtdotierender Fremdstoffpartikeln 21 zeitlich variiert. Dadurch wird die mittlere freie Weglänge für die freien Ladungsträger in der Kristallschicht 20 in Richtung x senkrecht zur Fläche 201 der Schicht 20, d.h. in Richtung senkrecht zu Oberfläche 11 des Substratkristalls 10 variiert.

Bei dem Körper 1 nach Figur 3 bestehen der Substratkristall 10 und die Kristallschicht 20 jeweils aus Silizium, und die Streuzentren 21' sind durch Fremdstoffpartikeln 21 in Form von Germaniumatomen und/oder Kohlenstoffatomen definiert.

Zusätzlich können Streuzentren 21' durch Eindiffundieren nichtdotierender Fremdstoffpartikeln 21 nach Abschluss der Epitaxie in die fertige Kristallschicht 20 erzeugt werden.

vorzugsweise besteht ein an die Oberfläche 11 des Substratkristalls 10 grenzender Teil 20' aus Halbleitermaterial des gleichen Leitungstyps wie das Halbleitermaterial des Kristallkörpers 10 der Kristallschicht 20, im Beispielsfall also des Leitungstyps n, und an eine von Oberfläche 11 des Substratkristalls 10 abgekehrte Oberfläche 202 dieses Teils20 grenzt ein Teil 20" aus Halbleitermaterial des zum Halbleitermaterial des Kristallkörpers 10 entgegengesetzten Leitungstyps p der Kristallschicht 20, welcher Teil 20" zugleich an die vom Substratkristall 10 abgekehrte Fläche 201 der Kristallschicht 20 grenzt.

Dies bedeutet, dass die Kristallschicht 20 und damit der Körper 1 einen pn-Übergang 100 zwischen p-dotiertem Halbleitermaterial und n-dotiertem Halbleitermaterial aufweist. Dieser Übergang 100 erstreckt in der Grenzfläche zwischen dem n-dotierten Halbleitermaterial und dem p-dotierten Halbleitermaterial der Kristallschicht 20, d. h. in der Fläche 202 der Kristallschicht 20.

In der Figur 4 ist eine Weiterbildung des Körpers 1 nach Figur 3 dergestalt dargestellt, dass auf die Kristallschicht 20 des Körpers 1, welche die kleinere mittlere freie Weglänge λr für die freien Ladungsträger CP aufweist, weiteres dotiertes Halbleitermaterial 30 des Körpers 1 aufgebracht ist, das eine mittlere freie Weglänge kann für die freien Ladungsträger CP aufweist, die größer als die kleinere mittlere freie Weglänge λr für die freien Ladungsträger CP der Kristallschicht 20 ist.

Das weitere dotierte Halbleitermaterial 30 des Körpers 1 kann beispielsweise aus zumindest einer durch Epitaxie auf die Fläche 201 der Kristallschicht 20 mit der kleineren mittleren freien Weglänge λr gewachsenen Kristallschicht aus dotiertem Halbleitermaterial bestehen.

Das Halbleitermaterial 30 kann auch aus einem beispielsweise dem Substratkristall 10 ähnlichen einkristallinen Kristallkörper aus dotiertem Halbleitermaterial bestehen, der durch Waferbonden mit einer freiliegenden Kristallschicht auf dem Substratkristall 10 verbunden ist. Beispielsweise sind die der Kristallschicht 20 zugekehrte Oberfläche 31 des Kristallkörpers 30 und die Fläche 201 der Kristallschicht 20 miteinander verbunden, wobei die Verbindung 23 zwischen den beiden Flächen 31 und 201 durch Waferbonden hergestellt ist.

Waferbonden an sich ist eine bekannte Verbindungstechnik (siehe z.B. Q.-Y. Tong, "Waferbonding and Wafer Splitting for Microsystems", Proceedings of the Electrochemical Society, 99-2, Seite 959 (1999)).

Bei der bevorzugten Ausführungsform des Beispiels nach Figur 4 ist das weitere dotierte Halbleitermaterial 30 des Körpers 1 wie der angrenzende Teil 20'' der Kristallschicht 20 p-dotiert und damit entgegengesetzt zum Substratskristall 10 dotiert.

Diese Ausführungsform des Körpers 1 nach Figur 4 hat besondere Vorteile, da die mittlere freie Weglänge des n-dotierten Halbleitermaterials der Kristallschicht 20 in Richtung × senkrecht zur Fläche 201 der Kristallschicht 20 derart variiert, dass die mittlere freie Weglänge, dort stärker reduziert ist, wo in der Kristallschicht 20 eine elektrische Feldstärke höher ist, und dort weniger stark reduziert ist, wo in der Kristallschicht 20 die elektrische Feldstärke kleiner ist. Derartige Feldstärken treten bekanntlich Anlegen einer elektrischen Sperrspannung an den Übergang 100 auf. Dadurch kann auch bewirkt werden, dass am Übergang 100 ein Anstieg der Durchlassspannung geringer ist als bei einer in der Richtung x homogenen Reduzierung der mittleren freien Weglänge für die freien Ladungsträger in der Kristallschicht 20 und dass somit auch ein verbesserter Kompromiss zwischen den Schaltverlusten und den im Durchlasszustand entstehenden Verlusten erzielt werden kann.

Durch die reduzierte mittlere freie Weglänge für die freien Ladungsträger in der Kristallschicht 20 kann insbesondere vorteilhafterweise die sogenannte kritische elektrische Feldstärke erheblich erhöht werden und dadurch bei einer bestimmten angelegten Sperrspannung die erforderliche Dicke einer Zone im Körper 1, die eine für das Erreichen dieser Sperrspannung erforderliche Raumladungszone aufnimmt, deutlich reduziert werden.

Somit kann mit einem Körper 1. jetzt auch bei elektronischen Bauelementen hoher Sperrfähigkeit von z.B. 2 bis 6 kV die elektrisch aktive Zone vollständig durch Epitaxie hergestellt werden.

Durch die Erfindung ist ein Halbleiterbauelement mit einem neuartigen Körper 1 aus dotiertem Halbleitermaterial geschaffen, der einen Substratkristall 10 aus dotiertem Halbleitermaterial mit einer bestimmten mittleren freien Weglänge λn für freie Ladungsträger CP und eine epitaktische Kristallschicht 20 aus dotiertem Halbleitermaterial auf dem Substratkristall 10 aufweist, die zumindest lokal eine zur bestimmten mittleren freien Weglänge λn kleinere mittlere freie Weglänge λr für die freien Ladungsträger CP aufweist.

Der Körper 1 weist zumindest einen pn-Übergang 100 zwischen p-dotiertem Halbleitermaterial und n-dotiertem Halbleitermaterial auf. Die Kristallschicht 20 kann aus p- und/oder n-dotiertem Halbleitermaterial bestehen.

Bei der Ausführungsform nach Figur 4 besteht beispielsweise die Kristallschicht 20 aus p-und n-dotiertem Halbleitermaterial und der pn-Übergang 100 erstreckt sich in der Fläche 202 der Kristallschicht 20.

Bestünde im Fall der Figur 3 oder 4 die Kristallschicht 20 aus p-dotiertem Halbleitermaterial, würde sich der pn Übergang 100 in der Oberfläche 11 des Substratkristalls 10 erstrecken.

Bestünde im Fall der Figur 3 die Kristallschicht 20 aus p-dotiertem Halbleitermaterial, würde sich der pn-Übergang 100 in der Oberfläche 11 des Substratkristalls 10 erstrecken.

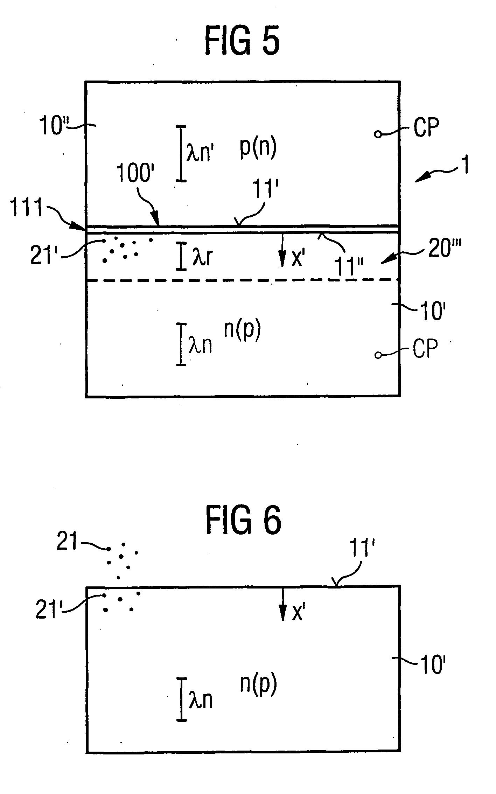

Der in der Figur 5 dargestellte Körper 1 aus dotiertem Halbleitermaterial, weist einen einheitlichen Kristallkörper 10' aus dotiertem Halbleitermaterial mit einer bestimmten mittleren freien Weglänge λn für freie Ladungsträger CP auf, der in einem an beispielsweise die nach oben gekehrte Oberfläche 11' des Kristallkörpers 10' grenzenden Bereich 20'eine zur bestimmten mittleren freien Weglänge Xn kleinere eine mittlere freie Weglänge λr für die freien Ladungsträger CP aufweist.

Der Bereich 20' kann sich über die ganze Oberfläche 11'oder nur über einen oder mehreren Teilbereichen der Fläche 11' erstrecken. In Richtung x senkrecht zur Oberfläche 11 des Kristallkörpers 10' erstreckt sich der Bereich 20''' vorzugsweise nur über einen Teil des Kristallkörpers 10'. In dieser Richtung x kann die kleinere mittlere freie Weglänge λr variieren.

Mit dem Kristallkörper 10' ist ein weiterer einheitlicher Kristallkörper 10" aus dotiertem Halbleitermaterial verbunden, dessen Halbleitermaterial eine mittlere freie Weglänge An' für die freien Ladungsträger CP aufweist, die größer als die kleinere mittlere freie Weglänge λr des Kristallkörpers 10' ist. Die Verbindung zwischen den beiden Kristallkörpern 10' und 10" ist durch Waferbonden hergestellt. Z. B. sind die einander zugekehrten Oberflächen11'und 11''der Kristallkörpers 10'und 10" miteinander verbunden, wobei die Verbindung 111 zwischen den beiden Flächen 11' und 11'' durch Waferbonden hergestellt ist.

Beispielsweise ist der Kristallkörper 10' n-dotiert und der Kristallkörper 10'' p-dotiert, was bedeutet dass der Körper 1 nach Figur 5 einen pn-Ubergang 100'zwischen p-dotiertem Halbleitermaterial und n-dotiertem Halbleitermaterial aufweist. Dieser Übergang 100' erstreckt in der Grenzfläche zwischen dem n-dotierten Kristallkörper10 und dem p-dotierten Kristallkörper 10, d. h. entlang der Flächen 11' und 11'' der Kristallkörper 10' und 10".

Der Bereich 20''' der kleineren mittleren freien Weglänge kr ist durch Streuzentren 21' im Kristallkörper 10 definiert, die im Kristallkörper 10' verteilt sind und die bestimmte mittlere freie Weglängekn des Halbleitermaterials dieses Körpers 10' reduzieren.

Die Streuzentren 21' werdern ähnlich wie beim Körper 1 nach den Figuren 2 bis 4 und wie in der Figur 6 angedeutet durch Einbringen von nichtdotierenden Fremdstoffpartikeln 21 in den Kristallkörper 10' erzeugt durch Beigabe nichtdotierender Fremdstoffpartikeln 21 während des Wachsens des Kristallkörpers 10' der bestimmten mittleren freien Weglänge λn in den Kristallkörper 10 und/oder durch Eindiffundieren nichtdotierender Fremdstoffpartikeln 21 in den Kristallkörper 10' erzeugt werden.

Eine in der Richtung x variierende kleinere mittlere freie Weglänge λr wird dadurch erzeugt, dass während des Wachsens des Kristallkörpers eine zur Erzeugung von Streuzentren 21' im Kristallkörper 10' angebotene Menge nicht dotierender Fremdstoffpartikeln 21 zeitlich variiert wird.

Je nach der gewünschten Dimensionierung eines mit dem Körper 1 nach Figur 5 hergestellten elektronischen Bauelements kann der Kristallkörper 10' und/oder der Kristallkörper 10'' durch Polieren und/oder Ätzschritte gedünnt werden. Danach können ggf. weitere Verfahrensschritte, die zur Fertigstellung des Bauelements erforderlich sind, durchgeführt werden.

## Patentansprüche

1. Verfahren zum Herstellen eines Halbleiterbauelements mit einem pn-Übergang, wobei das Verfahren aufweist:
Bereitstellen eines Substratkristalls (10) aus dotiertem Silizium mit einer bestimmten mittleren freien Weglänge (λn) für freie Ladungsträger (CP),
Wachsen einer Kristallschicht (20) aus n-dotiertem Silizium durch Epitaxie auf dem Substratkristall (10),
Erzeugen von Streuzentren (21') in der Kristallschicht (20) durch die Beigabe nichtdotierender Germaniumatome und/oder Kohlenstoffatome während des Kristallwachstums, derart, dass die Kristallschicht (20) zumindest lokal eine zur bestimmten mittleren freien Weglänge (λn) kleinere mittlere freie Weglänge (λr) für die freien Ladungsträger (CP) aufweist,
wobei während des Wachsens der Kristallschicht (20) eine zur Erzeugung der Streuzentren (21') in der Kristallschicht (20) angebotene Menge der Germaniumatome und/oder Kohlenstoffatome (21) derart zeitlich variiert wird, dass die mittlere freie Weglänge in der n-dotierten Kristallschicht (20) derart variiert, dass die mittlere freie Weglänge dort stärker reduziert ist, wo in der n-dotierten Kristallschicht (20) bei Anlegen einer Sperrspannung an den pn- Übergang eine elektrische Feldstärke höher ist und dort weniger stark reduziert ist, wo in der n-dotierten Kristallschicht (20) die Feldstärke kleiner ist, wobei der pn-Übergang durch Wachsen der Kristallschicht (20) auf einem p-dotierten Substratkristall (10) oder an einer dem Substratkristall (10) abgewandten Seite der Kristallschicht (20) hergestellt wird.

2. Verfahren nach Anspruch 1, wobei auf die Kristallschicht (20) mit der kleineren mittleren freien Weglänge (λr) für die freien Ladungsträger (CP) weiteres dotiertes Halbleitermaterial (30) aufgebracht wird, das eine mittlere freie Weglänge (λn') für die freien Ladungsträger (CP) aufweist, die größer als die kleinere mittlere freie Weglänge (λr) für die freien Ladungsträger (CP) der Kristallschicht (20) ist.

3. Verfahren nach Anspruch 2, wobei das weitere dotierte Halbleitermaterial (30) zumindest eine durch Epitaxie auf die Kristallschicht (20) mit der kleineren mittleren freien Weglänge (λr) gewachsene Kristallschicht (20') aus dotiertem Halbleitermaterial aufweist.

4. Verfahren nach Anspruch 2, wobei das weitere dotierte Halbleitermaterial (30) einen einkristallinen Kristallkörper (10") aus dotiertem Halbleitermaterial aufweist, der durch Waferbonden mit einer freiliegenden Kristallschicht (20, 20') auf dem Substratkristall (10) verbunden ist.

5. Verfahren nach einem der Ansprüche 2 bis 4, wobei das weitere dotierte Halbleitermaterial (30) einen Leitfähigkeitstyp (p; n) aufweist, der entgegengesetzt zu einem Leitfähigkeitstyp (n; p) des Substratskristalls (10) ist.

6. Halbleiterbauelement mit einem pen-Übergang, das aufweist:
einen Substratkristall (10) aus dotiertem Silizium mit einer bestimmten mittleren freien Weglänge (λn) für freie Ladungsträger (CP) und
eine epitaktische Kristallschicht (20) aus n-dotiertem Silizium auf dem Substratkristall (10),
wobei
die Kristallschicht (20) zumindest lokal während des Kristallwachstums eingebrachte nichtdotierende Germaniumatome und/oder Kohlenstoffatome als Streuzentren (21') und eine zur bestimmten mittleren freien Weglänge(λn) kleinere mittlere freie Weglänge (λr) für die freien Ladungsträger (CP) aufweist,
wobei die mittlere freie Weglänge in der n-dotierten Kristallschicht (20) derart variiert, dass die mittlere freie Weglänge dort stärker reduziert ist, wo in der n-dotierten Kristallschicht (20) bei Anlegen einer Sperrspannung an den pn- Übergang eine elektrische Feldstärke höher ist und dort weniger stark reduziert ist, wo in der n-dotierten Kristallschicht (20) die Feldstärke kleiner ist und wobei zwischen dem Substratkristall (10) und der Kristallschicht (20) oder an einer dem Substratkristall (10) abgewandten Seite der Kristallschicht (20) der pn-Übergang gebildet ist.

## Claims

1. Method for producing a semiconductor device having a pn junction, the method comprising:
providing a semiconductor crystal (10) of doped silicon having a predefined mean free path length (λn) for free charge carriers (CP),
epitaxially growing a crystal layer (20) of an n-doped silicon on the semiconductor crystal (10),
generating scattering centers (21') in the crystal layer (20) by adding non-doping germanium atoms and/or carbon atoms during crystal growth such that the crystal layer (20) at least locally has a smaller mean free path length (λr) for the free charge carriers than the predefined mean free path length (λn),
wherein during the crystal growth (20) an amount of germanium atoms and/or carbon atoms for generating the scattering centers (21') in the crystal layer (20) is timely varied such that
the mean free path length in the n-doped crystal layer varies such that the mean free path length is more reduced where in the n-doped crystal layer (20) an electric field strength is higher when a blocking voltage is applied to the pn-junction, and is less reduced where in the n-doped crystal layer (20) the field strength is smaller, wherein the pn-junction is produced by growing the crystal layer (20) on a p-doped semiconductor crystal (10) or on a side of the crystal layer (20) opposite the semiconductor crystal (10).

2. Method of claim 1, wherein on the crystal layer (20) with the smaller mean free path length (λr) for the free charge carriers (CP) a further doped semiconductor material (20) is disposed, the further semiconductor material having a mean free path length (λn') for the free charge carriers (CP) that is higher than the smaller mean free path length (λr) for the free charge carriers (CP) in the crystal layer (20).

3. Method of claim 2, wherein the further doped semiconductor material (20) comprises at least one crystal layer (20') of a doped semiconductor material epitaxially grown on the crystal layer (20) with the smaller mean free path length (λr).

4. Method of claim 2, wherein the further doped semiconductor material (30) comprises a monocrystalline semiconductor body (10'') of a doped semiconductor material that is connected with an uncovered crystal layer (20, 20') on the semiconductor crystal (10) by wafer bonding.

5. Method of one of claims 2 to 4, wherein the further doped semiconductor material (30) comprises a conduction type (p; n) opposite to the conduction type (n; p) of the semiconductor crystal (10).

6. Semiconductor device with a pn-junction, comprising:
a substrate crystal (10) of doped silicon with a predefined mean free path length (An) for free charge carriers (CP) and
an epitaxial crystal layer (20) of an n-doped silicon on the semiconductor crystal (10),
**characterized in that**
the crystal layer (20) comprises at least locally non-doping germanium atoms and/or carbon atoms as scattering centers (21') introduced during the crystal growth and a mean free path length (λr) for free charge carriers (CP) smaller than the predefined mean free path length (λn),
wherein the mean free path length in the n-doped crystal layer (20) varies such that the mean free path length is more reduced where in the n-doped crystal layer (20) an electrical field strength is higher when a blocking voltage is applied to the pn-junction and is reduced less where in the n-doped crystal layer (20) the field strength is smaller, and wherein
between the semiconductor crystal (10) and the crystal layer (20) or at a side of the crystal layer (20) opposite to the semiconductor crystal (10) a pn-junction is formed.

## Revendications

1. Procédé de fabrication d'un composant à semiconducteur ayant une jonction pn, procédé dans lequel :
on se procure un cristal (10) formant substrat en silicium dopé ayant une longueur (λn) moyenne de libre parcours pour des porteurs de charge (CP) libres,
on fait croître une couche (20) de cristal en silicium à dopage n par épitaxie sur le cristal (10) formant substrat,
on produit des centres (21') de dispersion dans la couche (20) de cristal par l'addition d'atomes de germanium et/ou d'atomes de carbone non dopant pendant la croissance du cristal de manière à ce que la couche (20) de cristal ait, au moins localement, une longueur (λr) moyenne de libre parcours pour les porteurs de charge (CP) libres plus petite que la longueur (λn) moyenne de libre parcours déterminée,
dans lequel, pendant la croissance de la couche (20) de cristal, on fait varier, dans le temps, le nombre des atomes de germanium et/ou des atomes de carbone apportés dans la couche (20) cristalline pour la production des centres (21') de dispersion de manière à ce que la longueur moyenne de libre parcours dans la couche (20) de cristal à dopage n soit modifiée, de manière à ce que la longueur moyenne de libre parcours y soit beaucoup réduite là où il y a dans la couche (20) de cristal à dopage n, lors de l'application d'une tension de blocage, à la jonction pn, une intensité du champ électrique plus grande et y soit moins réduite là où l'intensité du champ est plus petite dans la couche (20) de cristal à dopage n, la jonction pn étant produite par croissance de la couche (20) de cristal sur un cristal (10) formant substrat à dopage p ou sur une face de la couche (20) de cristal éloignée du cristal (10) formant substrat.

2. Procédé suivant la revendication 1, dans lequel on dépose sur la couche (20) de cristal ayant la longueur. (λr) moyenne de libre parcours la plus petite des porteurs de charge (CP) libres, un autre matériau (30) semiconducteur dopé, qui a une longueur (λn') moyenne de libre parcours des porteurs de charge (CP) libres plus grande que la longueur (λr) moyenne de libre parcours plus petite des porteurs de charge (CP) libres de la couche (20) de cristal.

3. Procédé suivant la revendication 2, dans lequel l'autre matériau (30) semiconducteur dopé a, au moins, une couche (20') de cristal en matériau semiconducteur dopé, obtenue par croissance par épitaxie, sur la couche (20) de cristal ayant la longueur (λr) moyenne de libre parcours plus petite.

4. Procédé suivant la revendication 2, dans lequel l'autre matériau (30) semiconducteur dopé a, au moins, un corps (10") de cristal monocristalin en matériau semiconducteur dopé qui est relié par liaison de tranche à une couche (20, 20') de cristal mise à nu sur le cristal (10) formant substrat.

5. Procédé suivant l'une des revendications 2 à 4, dans lequel l'autre matériau (30) semiconducteur dopé a un type (p, n) de conductivité, qui est opposé à un type (n, p) de conductivité du cristal (10) formant substrat.

6. Composant semiconducteur ayant une jonction pn qui comporte :
un cristal (10) formant substrat en silicium dopé, ayant une longueur (An) moyenne de libre parcours déterminée de porteurs de charge (CP) libres, et
une couche (20) de cristal épitaxiale, en silicium à dopage n sur le cristal (10) formant substrat, dans lequel la couche (20) de cristal a, au moins localement, des atomes de germanium et/ou des atomes de carbone non dopant et introduits au moins localement pendant la croissance du cristal comme centres (21') de dispersion et une longueur (λr) moyenne de libre parcours des porteurs de charge (CP) libres plus petite que la longueur (λn) de libre parcours moyenne déterminée, dans lequel la longueur moyenne de libre parcours dans la couche (20) de cristal à dopage n est modifiée, de manière à ce que la longueur moyenne de libre parcours y soit beaucoup réduite là où il y a dans la couche (20) de cristal à dopage n, lors de l'application d'une tension de blocage à la jonction pn, une intensité du champ électrique plus grande et y soit moins réduite là où l'intensité du champ est plus petite dans la couche (20) de cristal à dopage n et dans lequel la jonction pn est formée entre le cristal (10) formant substrat et la couche (20) de cristal ou sur une face de la couche (20) de cristal éloignée du cristal (10) formant substrat.
